# EUROPEAN PATENT SPECIFICATION

(11) **EP 4 224 182 B1**
(45) Date of publication and mention of the grant of the patent: **07.05.2025**
(21) Application number: 22853345.1
(22) Date of filing: 27.07.2022
(51) Int. Cl.: G01R 31/36, G01R 31/392, G01R 31/367, G01R 31/396, H01M 10/48, H01M 10/42, H01M 10/34, G01R 31/3828, G01R 31/3842

(54) **BATTERY MANAGEMENT APPARATUS AND METHOD**
BATTERIEVERWALTUNGSGERÄT UND VERFAHREN
APPAREIL ET MÉTHODE DE GESTION DE BATTERIE

(30) Priority: 02.08.2021 KR 20210101551
(43) Date of publication of application: 09.08.2023
(73) Proprietor: LG Energy Solution, Ltd., Seoul 07335 (KR)
(72) Inventor: CHA, A-Ming, Daejeon 34122 (KR); BAE, Yoon-Jung, Daejeon 34122 (KR)
(74) Representative: Goddar, Heinz J.
(86) International application number: PCT/KR2022/011075
(87) International publication number: WO 2023/013967

(56) References cited:
- EP-A1- 3 696 903
- EP-A2- 4 145 154
- JP-A- 2019 070 621
- JP-B2- 6 123 844
- JP-B2- 6 251 255
- KR-A- 20160 144 437
- KR-A- 20210 031 226
- US-A1- 2023 184 843

## Description

### TECHNICAL FIELD

The present disclosure relates to a battery management apparatus and method, and more particularly, to a battery management apparatus and method capable of diagnosing a state of a battery in a non-destructive manner.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

The battery may degrade as charging and discharging continue. For example, the state of the battery may be classified into BOL (Beginning of life), MOL (Middle of life) and EOL (End of life) according to the degree of degradation, and among them, the EOL battery may be treated as unusable.

Conventionally, the state of health (SOH) of the battery is estimated based on the change in capacity or internal resistance of the battery, or the state of the battery is diagnosed through VOLCANO analysis (a method of analyzing a differential profile (V-dQdV profile or Q-dVdQ profile)).

In particular, when the state of the battery is the EOL state, it is preferable that the corresponding battery be treated as unusable. However, if there is an error in diagnosing the state of the battery or the state of the battery is not quickly diagnosed, the battery in the EOL state may be used, which may cause an unexpected accident.

EP 3 696 903 A1 discloses a battery management apparatus. The battery management apparatus includes a sensing unit configured to generate battery information indicating a voltage and current of a battery, and a control unit operably coupled to the sensing unit. The control unit determines a differential voltage curve based on a history of the battery information during a sensing period while the battery is being charged with a current of a first current rate. The control unit detects a plurality of feature points from the differential voltage curve. The control unit determines whether stabilization for an electrode material of the battery is required, based on a feature value of each of the plurality of feature points. The control unit outputs a control signal to induce the battery to be discharged with a current of a second current rate, when it is determined that stabilization for the electrode material of the battery is required. The second current rate is smaller than the first current rate.

### DISCLOSURE

### Technical Problem

The present disclosure is designed to solve the problems of the related art, and therefore the present disclosure is directed to providing a battery management apparatus and method capable of diagnosing a state of a battery in a non-destructive manner through differential profile analysis.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to an embodiment of the invention comprises: a profile generating unit configured to generate a differential profile for a battery profile representing a corresponding relationship between voltage and capacity of a battery; and a control unit configured to determine a criterion peak and a target peak in the differential profile received from the profile generating unit, and diagnose a state of the battery based on a result of comparing a differential value of the criterion peak and a differential value of the target peak.

The profile generating unit may be configured to generate at least one of a differential voltage profile representing a corresponding relationship between the capacity and a differential voltage for the capacity and a differential capacity profile representing a corresponding relationship between the voltage and a differential capacity for the voltage, as the differential profile.

The control unit may be configured to determine the type of the differential profile received from the profile generating unit, and determine the criterion peak and the target peak in the received differential profile according to a rule preset to correspond to the determined type of the differential profile.

When the differential voltage profile is received from the profile generating unit, the control unit may be configured to classify the differential voltage profile into a criterion region and a target region according to the capacity, determine a peak with the smallest differential voltage in the criterion region as the criterion peak, and determine a peak with the smallest differential voltage in the target region as the target peak.

When a differential voltage value of the criterion peak is less than a differential voltage value of the target peak, the control unit may be configured to diagnose the state of the battery as an unusable state.

When the differential voltage value of the criterion peak is equal to or greater than the differential voltage value of the target peak, the control unit may be configured to diagnose the state of the battery as a usable state.

When the differential capacity profile is received from the profile generating unit, the control unit may be configured to classify the differential capacity profile into a criterion region and a target region according to the voltage, determine a peak with the greatest differential capacity in the criterion region as the criterion peak, and determine a peak with the greatest differential capacity in the target region as the target peak.

When a differential capacity value of the criterion peak exceeds a differential capacity value of the target peak, the control unit may be configured to diagnose the state of the battery as an unusable state.

When the differential capacity value of the criterion peak is equal to or less than the differential capacity value of the target peak, the control unit may be configured to diagnose the state of the battery as a usable state.

The target peak may be configured to appear in a differential profile for a high nickel-based battery containing a predetermined amount of nickel or more.

A battery pack according to another aspect of the present disclosure may comprise the battery management apparatus according to an aspect of the present disclosure.

A battery management method according to an embodiment of the invention comprises: a differential profile generating step of generating a differential profile for a battery profile representing a corresponding relationship between voltage and capacity of a battery; a peak determining step of determining a criterion peak and a target peak in the differential profile generated in the differential profile generating step; and a battery state diagnosing step of diagnosing a state of the battery based on a result of comparing a differential value of the criterion peak and a differential value of the target peak.

### Advantageous Effects

According to the invention, the state of the battery may be diagnosed in a non-destructive manner through differential profile analysis. In particular, whether the state of the battery is an unusable state may be specifically diagnosed.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery management apparatus according to an embodiment of the present disclosure.
FIG. 2 is a diagram schematically showing a differential voltage profile according to an embodiment of the present disclosure.
FIG. 3 is a diagram schematically showing a differential capacity profile according to an embodiment of the present disclosure.
FIG. 4 is a diagram schematically showing an exemplary configuration of a battery pack according to another embodiment of the present disclosure.
FIG. 5 is a diagram schematically showing a battery management method according to still another embodiment of the present disclosure.

### DETAILED DESCRIPTION

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

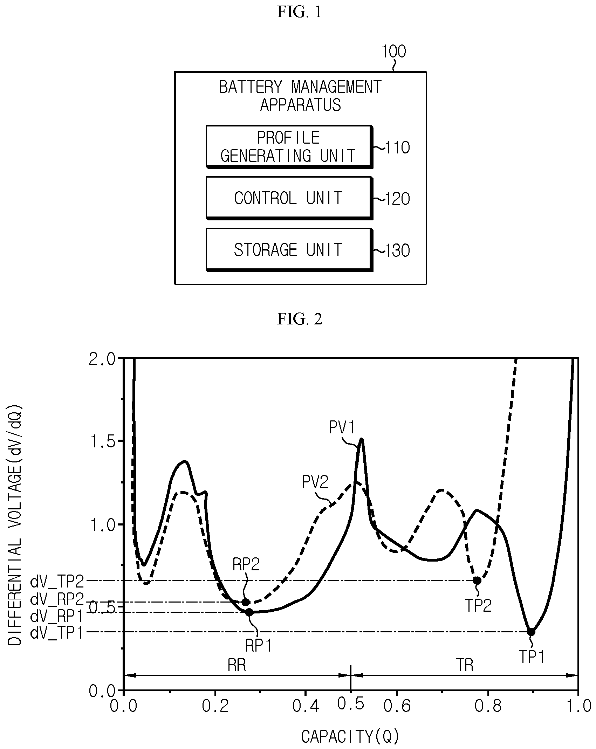

FIG. 1 is a diagram schematically showing a battery management apparatus 100 according to an embodiment of the present disclosure.

Referring to FIG. 1, the battery management apparatus 100 according to an embodiment of the present disclosure includes a profile generating unit 110 and a control unit 120.

The profile generating unit 110 is configured to generate a differential profile for a battery profile representing a corresponding relationship between voltage and capacity of a battery.

Here, the battery means one physically separable independent cell including a negative electrode terminal and a positive electrode terminal. For example, one lithium-ion battery or lithium polymer battery may be regarded as a battery. Also, the battery may refer to a battery module in which a plurality of cells are connected in series and/or in parallel. Hereinafter, for convenience of explanation, the battery will be described as meaning one independent cell.

Specifically, the profile generating unit 110 may directly receive the battery profile from the outside or may directly generate the battery profile by periodically receiving the voltage and capacity of the battery from the outside.

For example, the battery profile may represent a corresponding relationship between the capacity (Q) and voltage (V) of the battery. Here, the unit of capacity may be [mAh], and the unit of voltage may be [V]. In addition, the battery profile may be expressed as an X-Y two-dimensional graph, when X is set as capacity and Y is set as voltage.

In addition, the profile generating unit 110 may generate a differential profile corresponding to the first derivative of the battery profile. For example, the profile generating unit 110 may generate a differential capacity profile representing a corresponding relationship between the voltage (V) and the differential capacity (dQ/dV) and/or a differential voltage profile representing a corresponding relationship between the capacity (Q) and the differential voltage (dV/dQ).

The control unit 120 is configured to determine a criterion peak and a target peak in the differential profile received from the profile generating unit 110.

Specifically, the control unit 120 may classify the region of the differential profile into a criterion region RR and a target region TR that do not overlap each other. In addition, the control unit 120 may determine the criterion peak in the criterion region RR and determine the target peak in the target region TR.

The control unit 120 may be configured to diagnose the state of the battery based on a result of comparing a differential value of the criterion peak and a differential value of the target peak.

For example, the control unit 120 may compare the magnitudes of the differential value of the criterion peak and the differential value of the target peak, and diagnose the state of the battery as an unusable state or a usable state according to the comparison result. Here, the unusable state may mean a state in which the state of the battery is an EOL state, and thus the battery cannot be used. The usable state may mean a state in which the state of the battery is a BOL or MOL state, and thus the battery can be used.

In general, a battery in the EOL state is a battery that has undergone a considerable amount of degradation, and may mean a battery having an SOH of 70% or less. The battery in the EOL state is in a state in which positive electrode capacity and/or usable lithium is lost, and in some cases, lithium plating (Li-plating) from which metallic lithium is deposited may occur on the surface of the negative electrode. Therefore, if the battery in the EOL state is continuously used, unexpected accidents such as explosion and/or fire may occur due to an internal short circuit.

The control unit 120 may diagnose the state of the battery by determining both the differential value of the criterion peak that can serve as the criterion value and the differential value of the target peak that that can serve as the comparison value in consideration of one differential profile for the battery.

That is, the battery management apparatus 100 may determine the state of the battery by comparing the differential values of two peaks that can be determined from the differential profile, without comparing the differential value of a peak determined from the differential profile with a specific value that is preset uniformly. Accordingly, the battery management apparatus 100 has an advantage of more accurately diagnosing the current state of the battery by adopting a diagnosing method that can reflect the current state of the battery in a best way.

Meanwhile, the profile generating unit 110 and the control unit 120 provided in the battery management apparatus 100 may selectively include processors known in the art, application-specific integrated circuit (ASIC), other chipsets, logic circuits, registers, communication modems, data processing devices, and the like to execute various control logic performed in the present disclosure. Also, when the control logic is implemented in software, the profile generating unit 110 and the control unit 120 may be implemented as a set of program modules. At this time, the program module may be stored in a memory and executed by the profile generating unit 110 and the control unit 120. The memory may be located inside or out of each of the profile generating unit 110 and the control unit 120 and may be connected to the profile generating unit 110 and the control unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its type as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

Preferably, the target peak may be configured to appear in a differential profile for a high nickel-based battery containing a certain amount of nickel or more.

In general, the high nickel-based battery may mean a battery in which the content of nickel contained in the positive electrode material is 80% or more. Conversely, a low nickel-based battery may mean a battery in which the content of nickel contained in the positive electrode material is less than 80%. For example, an NCM battery having a ratio of nickel (N), cobalt (C) and manganese (M) of 8:1:1 or 9:½:½ may be the high nickel-based battery.

In addition, the target peak determined by the control unit 120 may be a peak appearing in the high nickel-based battery.

In general, phase equilibrium may occur during battery charging. In addition, when phase equilibrium occurs, the peak of the differential profile of the battery may appear. For example, when four phase equilibrium occurs, Ec (1), Ec (2), Ec (3) and Ec (4) peaks may be sequentially included in the differential profile. In addition, in order to generate the fourth phase equilibrium corresponding to the Ec (4) peak, the content of nickel included in the positive electrode material of the battery may be 80% or more. For example, the Ec (2) peak corresponding to the second phase equilibrium may correspond to the criterion peak, and the Ec (4) peak corresponding to the fourth phase equilibrium may correspond to the target peak.

On the other hand, if the content of nickel included in the positive electrode material is less than 80%, the fourth phase equilibrium may not occur, and even if the fourth phase equilibrium occurs, a corresponding target peak may not be generated.

Therefore, since the battery management apparatus 100 according to an embodiment of the present disclosure uses a battery in which the content of nickel contained in the positive electrode material is 80% or more, it is possible to clearly determine the target peak in the differential profile. Accordingly, the battery management apparatus 100 may more specifically diagnose the state of the battery.

The profile generating unit 110 may be configured to generate at least one of a differential voltage profile representing a corresponding relationship between the capacity and a differential voltage for the capacity and a differential capacity profile representing a corresponding relationship between the voltage and a differential capacity for the voltage, as the differential profile.

FIG. 2 is a diagram schematically showing a differential voltage profile according to an embodiment of the present disclosure. Specifically, FIG. 2 is a diagram showing a first differential voltage profile PV1 for a first battery and a second differential voltage profile PV2 for a second battery.

Referring to FIG. 2, the differential voltage profile may represent a corresponding relationship between a capacity (Q) and a differential voltage (dV/dQ) for the capacity (Q). Here, the differential voltage (dV/dQ) may be calculated as an instantaneous rate of change of the voltage (V) with respect to the capacity (Q).

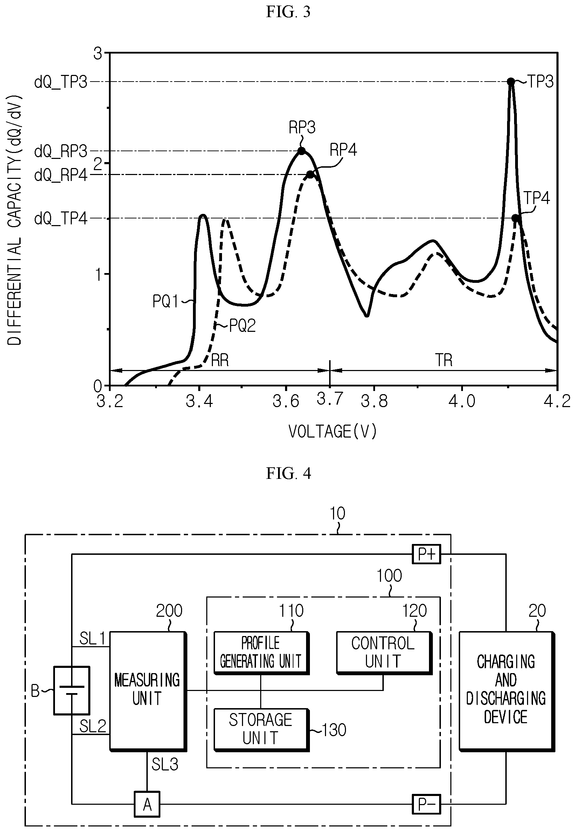

FIG. 3 is a diagram schematically showing a differential capacity profile according to an embodiment of the present disclosure. Specifically, FIG. 3 is a diagram showing a first differential capacity profile PQ1 for the first battery and a second differential capacity profile PQ2 for the second battery.

Referring to FIG. 3, the differential capacity profile may represent a corresponding relationship between a voltage (V) and a differential capacity (dQ/dV) for the voltage (V). Here, the differential capacity (dQ/dV) may be calculated as an instantaneous rate of change of the capacity (Q) with respect to the voltage (V).

The control unit 120 may be configured to determine the type of the differential profile received from the profile generating unit 110.

For example, when receiving the differential profile from the profile generating unit 110, the control unit 120 may receive information on the type of the differential profile together. Accordingly, the control unit 120 may clearly classify the type of the differential profile generated by the profile generating unit 110 as a differential capacity profile or a differential voltage profile.

As another example, the profile generating unit 110 may be preconfigured to generate one type of differential profile. In addition, the profile generating unit 110 may be configured to generate a different type of differential profile when there is a request from the control unit 120. Accordingly, the control unit 120 may clearly classify the type of the differential profile received from the profile generating unit 110.

The control unit 120 may be configured to determine the criterion peak and the target peak in the received differential profile according to a rule preset to correspond to the determined type of the differential profile.

Specifically, the control unit 120 may determine the criterion peak and the target peak in the differential capacity profile and the differential voltage profile in different ways. Since the differential capacity profile and the differential voltage profile are differential profiles representing a corresponding relationship between different factors, the control unit 120 may determine the criterion peak and the target peak according to a rule corresponding to the type of the differential profile, respectively.

When the control unit 120 receives the differential voltage profile from the profile generating unit 110, the control unit 120 may be configured to classify the differential voltage profile into a criterion region RR and a target region TR according to capacity. For example, the control unit 120 may half the capacity region of the differential voltage profile and classify a low capacity region as the criterion region RR and a high capacity region as the target region TR.

In the embodiment of FIG. 2, the capacity (Q) of the differential voltage profile is normalized to a range of 0 mAh to 1 mAh. The control unit 120 may half the capacity region of the differential voltage profile, so that a low capacity region of 0 mAh to 0.5 mAh is set as the criterion region RR, and a high capacity region of 0.5 mAh to 1 mAh is set as the target region TR.

In addition, the control unit 120 may be configured to determine a peak with the smallest differential voltage in the criterion region RR as the criterion peak, and determine a peak with the smallest differential voltage in the target region TR as the target peak.

For example, in the embodiment of FIG. 2, the criterion region RR of the first differential voltage profile PV1 may include a first criterion peak RP1, and the differential voltage value of the first criterion peak RP1 may be dV_RP1. In addition, the target region TR of the first differential voltage profile PV1 may include a first target peak TP1, and the differential voltage value of the first target peak TP1 may be dV_TP1. The criterion region RR of the second differential voltage profile PV2 may include a second criterion peak RP2, and the differential voltage value of the second criterion peak RP2 may be dV_RP2. In addition, the target region TR of the second differential voltage profile PV2 may include a second target peak TP2, and the differential voltage value of the second target peak TP2 may be dV_TP2.

When the differential voltage value of the criterion peak is less than the differential voltage value of the target peak, the control unit 120 may diagnose the state of the battery as an unusable state. Conversely, when the differential voltage value of the criterion peak is equal to or greater than the differential voltage value of the target peak, the control unit 120 may diagnose the state of the battery as a usable state.

In general, in the differential voltage profile, as the battery degrades, the capacity value corresponding to the target peak is shifted to the low capacity side, and the differential voltage value corresponding to the target peak may be increased. That is, in the embodiment of FIG. 2, the second battery corresponding to the second differential voltage profile PV2 may be more degraded than the first battery corresponding to the first differential voltage profile PV1.

In the embodiment of FIG. 2, since the differential voltage value (dV_RP1) of the first criterion peak RP1 included in the first differential voltage profile PV1 is equal to or greater than the differential voltage value (dV_TP1) of the first target peak TP1, the control unit 120 may diagnose the state of the first battery corresponding to the first differential voltage profile PV1 as a usable state. Conversely, since the differential voltage value (dV_RP2) of the second criterion peak RP2 included in the second differential voltage profile PV2 is less than the differential voltage value (dV_TP2) of the second target peak TP2, the control unit 120 may diagnose the state of the second battery corresponding to the second differential voltage profile PV2 as an unusable state.

Preferably, the control unit 120 may be configured to block charging and discharging of the second battery so that the second battery diagnosed as an unusable state is not used. For example, the control unit 120 may block charging and discharging of the second battery by controlling the relay connected to the positive electrode terminal and/or the negative electrode terminal of the second battery to a turn-off state. As another example, in order to indicate that the second battery is in an unusable state, the control unit 120 may label the state of the battery as an unusable state in the battery information about the second battery.

When receiving the differential capacity profile from the profile generating unit 110, the control unit 120 may be configured to classify the differential capacity profile into a criterion region RR and a target region TR according to voltage. For example, the control unit 120 may half the voltage region of the differential capacity profile, and classify a low voltage region as the criterion region RR and a high voltage region as the target region TR.

In the embodiment of FIG. 3, the voltage region of the differential capacity profile may be 3.2 [V] to 4.2 [V]. The control unit 120 may half the voltage region of the differential capacity profile, so that a low voltage region of 3.2 V to 3.7 V is set as the criterion region RR, and a high voltage region of 3.7 V to 4.2 V is set as the target region TR.

The control unit 120 may be configured to determine a peak with the greatest differential capacity in the criterion region RR as the criterion peak, and determine a peak with the greatest differential capacity in the target region TR as the target peak.

For example, in the embodiment of FIG. 3, the criterion region RR of the first differential capacity profile PQ1 may include a third criterion peak RP3, and the differential capacity value of the third criterion peak RP3 may be dQ_RP3. In addition, the target region TR of the first differential capacity profile PQ1 may include a third target peak TP3, and the differential capacity value of the third target peak TP3 may be dQ_TP3. The criterion region RR of the second differential capacity profile PQ2 may include a fourth criterion peak RP4, and the differential capacity value of the fourth criterion peak RP4 may be dQ_RP4. In addition, the target region TR of the second differential capacity profile PQ2 may include a fourth target peak TP4, and the differential capacity value of the fourth target peak TP4 may be dQ_TP4.

The control unit 120 may be configured to diagnose the state of the battery as an unusable state when the differential capacity value of the criterion peak exceeds the differential capacity value of the target peak, and diagnose the state of the battery as a usable state when the differential capacity value of the criterion peak is less than or equal to the differential capacity value of the target peak.

In general, in the differential capacity profile, as the battery degrades, the differential capacity value corresponding to the target peak may be reduced. That is, in the embodiment of FIG. 3, the second battery corresponding to the second differential capacity profile PQ2 may be more degraded than the first battery corresponding to the first differential capacity profile PQ1.

In the embodiment of FIG. 3, since the differential capacity value (dQ_RP3) of the third criterion peak RP3 included in the first differential capacity profile PQ1 is less than or equal to the differential capacity value (dQ_TP3) of the third target peak TP3, the control unit 120 may diagnose the state of the first battery corresponding to the first differential capacity profile PQ1 as a usable state. Conversely, since the differential capacity value (dQ_RP4) of the fourth criterion peak RP4 included in the second differential capacity profile PQ2 exceeds the differential capacity value (dQ_TP4) of the fourth target peak TP4 (dQ_TP4), the control unit 120 may diagnose the state of the second battery corresponding to the second differential capacity profile PQ2 as an unusable state.

Preferably, the control unit 120 may be configured to block charging and discharging of the second battery so that the second battery diagnosed as an unusable state is not used. For example, the control unit 120 may block charging and discharging of the second battery by controlling the relay connected to the positive electrode terminal and/or the negative electrode terminal of the second battery to a turn-off state. As another example, in order to indicate that the second battery is in an unusable state, the control unit 120 may label the state of the battery as an unusable state in the battery information about the second battery.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS. For example, the profile generating unit 110, the control unit 120 and the storage unit 130 may be implemented as components of the BMS.

The battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

FIG. 4 is a diagram schematically showing an exemplary configuration of a battery pack according to another embodiment of the present disclosure.

The positive electrode terminal of the battery B may be connected to the positive electrode terminal P+ of the battery pack 10, and the negative electrode terminal of the battery B may be connected to the negative electrode terminal P- of the battery pack 10.

A measuring unit 200 may be connected to a first sensing line SL1, a second sensing line SL2, and a third sensing line SL3. Specifically, the measuring unit 200 may be connected to a positive electrode terminal of the battery B through the first sensing line SL1, and may be connected to a negative electrode terminal of the battery B through the second sensing line SL2. The measuring unit 200 may measure the voltage of the battery B based on the voltage measured at each of the first sensing line SL1 and the second sensing line SL2.

In addition, the measuring unit 200 may be connected to an ampere meter A through the third sensing line SL3. For example, the ampere meter A may be an ammeter or a shunt resistor capable of measuring the charging current and the discharging current of the battery B. The measuring unit 200 may calculate the amount of charge by measuring the charging current of the battery B through the third sensing line SL3. Also, the measuring unit 200 may calculate the amount of discharge by measuring the discharge current of the battery B through the third sensing line SL3.

One end of the charging and discharging device 20 may be connected to the positive electrode terminal P+ of the battery pack 10, and the other end may be connected to the negative electrode terminal P- of the battery pack 10. Therefore, the positive electrode terminal of the battery B, the positive electrode terminal P+ of the battery pack 10, the charging and discharging device 20, the negative electrode terminal P- of the battery pack 10, and the negative electrode terminal of the battery B may be electrically connected.

For example, the battery management apparatus 100 may be applied to a state diagnosing device for a reuse battery that diagnoses the state of a reuse battery.

Recently, as interest in eco-friendly energy increases, the use of batteries is increasing. Since a battery has a limit that cannot but degrade as it is used, whether or not the battery can be recycled may be determined according to the state of the battery. For example, a battery firstly used in a vehicle may be reused in an energy storage system (ESS).

In general, the battery in the MOL state may be reused in the secondary or tertiary use, but the battery in the EOL state may not be reusable. Accordingly, the battery management apparatus 100 may determine whether or not to reuse a collected battery by diagnosing the state of the collected battery in order to judge whether or not to reuse it.

For example, the battery management apparatus 100 may diagnose whether the state of the collected battery is an unusable state or a usable state by comparing the differential value of the criterion peak and the differential value of the target peak in the differential profile of the collected battery.

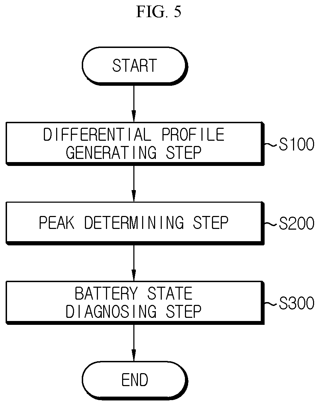

FIG. 5 is a diagram schematically showing a battery management method according to still another embodiment of the present disclosure.

Preferably, each step of the battery management method may be performed by the battery management apparatus 100. Hereinafter, contents overlapping with the previously described contents will be omitted or briefly described.

The differential profile generating step (S100) is a step of generating a differential profile for a battery profile representing a corresponding relationship between voltage and capacity of a battery, and may be performed by the profile generating unit 110.

For example, the profile generating unit 110 may be configured to generate at least one of a differential voltage profile representing a corresponding relationship between a capacity and a differential voltage for the capacity and a differential capacity profile representing a corresponding relationship between a voltage and a differential capacity for the voltage.

The peak determining step (S200) is a step of determining a criterion peak and a target peak in the differential profile generated in the differential profile generating step (S100), and may be performed by the control unit 120.

For example, when the control unit 120 receives the differential voltage profile from the profile generating unit 110, the control unit 120 may classify the capacity region of the differential voltage profile into a criterion region RR and a target region TR, determine the criterion peak in the criterion region RR, and determine the target peak in the target region TR.

As another example, when the control unit 120 receives the differential capacity profile from the profile generating unit 110, the control unit 120 may classify the voltage region of the differential capacity profile into a criterion region RR and a target region TR, determine the criterion peak in the criterion region RR, and determine the target peak in the target region TR.

The battery state diagnosing step (S300) is a step of diagnosing the state of the battery based on a result of comparing the differential value of the criterion peak and the differential value of the target peak, and may be performed by the control unit 120.

For example, when the control unit 120 receives the differential voltage profile from the profile generating unit 110, the control unit 120 may diagnose the state of the battery as an unusable state if the differential voltage value of the criterion peak is less than the differential voltage value of the target peak. Conversely, if the differential voltage value of the criterion peak is equal to or greater than the differential voltage value of the target peak, the control unit 120 may diagnose the state of the battery as a usable state.

As another example, when the control unit 120 receives the differential capacity profile from the profile generating unit 110, the control unit 120 may diagnose the state of the battery as an unusable state if the differential capacity value of the criterion peak exceeds the differential capacity value of the target peak. In addition, if the differential capacity value of the criterion peak is less than or equal to the differential capacity value of the target peak, the control unit 120 may be configured to diagnose the state of the battery as a usable state.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the claims will become apparent to those skilled in the art from this detailed description.

### (Reference Signs)

10: battery pack
20: charging and discharging device
100: battery management apparatus
110: profile generating unit
120: control unit
130: storage unit
200: measuring unit

## Claims

1. A battery management apparatus (100), comprising:
a profile generating unit (110) configured to generate a differential profile for a battery profile representing a corresponding relationship between voltage and capacity of a battery; and
a control unit (120) configured to determine a criterion peak and a target peak in the differential profile received from the profile generating unit (110);
**characterized in that**
the control unit (120) is further configured diagnose a state of the battery based on a result of comparing a differential value of the criterion peak and a differential value of the target peak.

2. The battery management apparatus (100) according to claim 1,
wherein the profile generating unit (110) is configured to generate at least one of a differential voltage profile representing a corresponding relationship between the capacity and a differential voltage for the capacity and a differential capacity profile representing a corresponding relationship between the voltage and a differential capacity for the voltage, as the differential profile.

3. The battery management apparatus (100) according to claim 2,
wherein the control unit (120) is configured to determine the type of the differential profile received from the profile generating unit (110), and determine the criterion peak and the target peak in the received differential profile according to a rule preset to correspond to the determined type of the differential profile.

4. The battery management apparatus (100) according to claim 3,
wherein when the differential voltage profile is received from the profile generating unit (110), the control unit (120) is configured to classify the differential voltage profile into a criterion region and a target region according to the capacity, determine a peak with the smallest differential voltage in the criterion region as the criterion peak, and determine a peak with the smallest differential voltage in the target region as the target peak.

5. The battery management apparatus (100) according to claim 4,
wherein when a differential voltage value of the criterion peak is less than a differential voltage value of the target peak, the control unit (120) is configured to diagnose the state of the battery as an unusable state, and
wherein when the differential voltage value of the criterion peak is equal to or greater than the differential voltage value of the target peak, the control unit (120) is configured to diagnose the state of the battery as a usable state.

6. The battery management apparatus (100) according to claim 3,
wherein when the differential capacity profile is received from the profile generating unit (110), the control unit (120) is configured to classify the differential capacity profile into a criterion region and a target region according to the voltage, determine a peak with the greatest differential capacity in the criterion region as the criterion peak, and determine a peak with the greatest differential capacity in the target region as the target peak.

7. The battery management apparatus (100) according to claim 6,
wherein when a differential capacity value of the criterion peak exceeds a differential capacity value of the target peak, the control unit (120) is configured to diagnose the state of the battery as an unusable state, and
wherein when the differential capacity value of the criterion peak is equal to or less than the differential capacity value of the target peak, the control unit (120) is configured to diagnose the state of the battery as a usable state.

8. The battery management apparatus (100) according to claim 1,
wherein the target peak is configured to appear in a differential profile for a high nickel-based battery containing a predetermined amount of nickel or more.

9. The battery management apparatus (100) according to one of claims 1 to 8, wherein the state of the battery includes a usable state and an unusable state. [page 9, lines 1-10]

10. A battery pack (10), comprising the battery management apparatus (100) according to any one of claims 1 to 9.

11. A battery management method, comprising:
a differential profile generating step of generating a differential profile for a battery profile representing a corresponding relationship between voltage and capacity of a battery; and
a peak determining step of determining a criterion peak and a target peak in the differential profile generated in the differential profile generating step;
**characterized by**
a battery state diagnosing step of diagnosing a state of the battery based on a result of comparing a differential value of the criterion peak and a differential value of the target peak.

## Patentansprüche

1. Batterieverwaltungsvorrichtung (100) aufweisend:
eine Profilerzeugungseinheit (110), die konfiguriert ist, um ein Differenzprofil für ein Batterieprofil zu erzeugen, das eine zugehörige Beziehung zwischen Spannung und Kapazität einer Batterie darstellt; und
eine Steuereinheit (120), die konfiguriert ist, um eine Kriteriumsspitze und eine Targetspitze in dem von der Profilerzeugungseinheit (110) empfangenen Differenzprofil zu bestimmen;
**dadurch gekennzeichnet, dass**
die Steuereinheit (120) ferner konfiguriert ist, um einen Zustand der Batterie basierend auf einem Ergebnis eines Vergleichs eines Differenzwerts der Kriteriumsspitze und eines Differenzwerts der Targetspitze zu diagnostizieren.

2. Batterieverwaltungsvorrichtung (100) nach Anspruch 1,
wobei die Profilerzeugungseinheit (110) konfiguriert ist, um mindestens eines von einem Differenzspannungsprofil, das eine zugehörige Beziehung zwischen der Kapazität und einer Differenzspannung für die Kapazität darstellt, und einem Differenzkapazitätsprofil, das eine zugehörige Beziehung zwischen der Spannung und einer Differenzkapazität für die Spannung darstellt, als das Differenzprofil zu erzeugen.

3. Batterieverwaltungsvorrichtung (100) nach Anspruch 2,
wobei die Steuereinheit (120) konfiguriert ist, um den Typ des von der Profilerzeugungseinheit (110) empfangenen Differenzprofils zu bestimmen und die Kriteriumsspitze und die Targetspitze in dem empfangenen Differenzprofil gemäß einer Regel zu bestimmen, die voreingestellt ist, um dem bestimmten Typ des Differenzprofils zu entsprechen.

4. Batterieverwaltungsvorrichtung (100) nach Anspruch 3,
wobei, wenn das Differenzspannungsprofil von der Profilerzeugungseinheit (110) empfangen wird, die Steuereinheit (120) konfiguriert ist, um das Differenzspannungsprofil in einen Kriteriumsbereich und einen Targetbereich gemäß der Kapazität zu klassifizieren, eine Spitze mit der kleinsten Differenzspannung in dem Kriteriumsbereich als die Kriteriumsspitze zu bestimmen und eine Spitze mit der kleinsten Differenzspannung in dem Targetbereich als die Targetspitze zu bestimmen.

5. Batterieverwaltungsvorrichtung (100) nach Anspruch 4,
wobei, wenn ein Differenzspannungswert der Kriteriumsspitze kleiner als ein Differenzspannungswert der Targetspitze ist, die Steuereinheit (120) konfiguriert ist, um den Zustand der Batterie als einen unbrauchbaren Zustand zu diagnostizieren, und
wobei, wenn der Differenzspannungswert der Kriteriumsspitze gleich oder größer als der Differenzspannungswert der Targetspitze ist, die Steuereinheit (120) konfiguriert ist, um den Zustand der Batterie als einen brauchbaren Zustand zu diagnostizieren.

6. Batterieverwaltungsvorrichtung (100) nach Anspruch 3,
wobei, wenn das Differenzkapazitätsprofil von der Profilerzeugungseinheit (110) empfangen wird, die Steuereinheit (120) konfiguriert ist, um das Differenzkapazitätsprofil in einen Kriteriumsbereich und einen Targetbereich gemäß der Spannung zu klassifizieren, eine Spitze mit der größten Differenzkapazität in dem Kriteriumsbereich als die Kriteriumsspitze zu bestimmen und eine Spitze mit der größten Differenzkapazität in dem Targetbereich als die Targetspitze zu bestimmen.

7. Batterieverwaltungsvorrichtung (100) nach Anspruch 6,
wobei, wenn ein Differenzkapazitätswert der Kriteriumsspitze einen Differenzkapazitätswert der Targetspitze überschreitet, die Steuereinheit (120) konfiguriert ist, um den Zustand der Batterie als einen unbrauchbaren Zustand zu diagnostizieren, und
wobei, wenn der Differenzkapazitätswert der Kriteriumsspitze gleich oder kleiner als der Differenzkapazitätswert der Targetspitze ist, die Steuereinheit (120) konfiguriert ist, um den Zustand der Batterie als einen brauchbaren Zustand zu diagnostizieren.

8. Batterieverwaltungsvorrichtung (100) nach Anspruch 1,
wobei die Targetspitze konfiguriert ist, um in einem Differenzprofil für eine Batterie auf Basis von hohem Nickel zu erscheinen, die eine vorbestimmte Menge an Nickel oder mehr enthält.

9. Batterieverwaltungsvorrichtung (100) nach einem der Ansprüche 1 bis 8, wobei der Zustand der Batterie einen brauchbaren Zustand und einen unbrauchbaren Zustand enthält.

10. Batteriepack (10) aufweisend die Batterieverwaltungsvorrichtung (100) nach einem der Ansprüche 1 bis 9.

11. Batterieverwaltungsverfahren aufweisend:
einen Differenzprofilerzeugungsschritt des Erzeugens eines Differenzprofils für ein Batterieprofil, das eine zugehörige Beziehung zwischen Spannung und Kapazität einer Batterie darstellt; und
einen Spitzenbestimmungsschritt des Bestimmens einer Kriteriumsspitze und einer Targetspitze in dem in dem Differenzprofilerzeugungsschritt erzeugten Differenzprofil;
**gekennzeichnet durch**
einen Batteriezustandsdiagnoseschritt des Diagnostizierens eines Zustands der Batterie basierend auf einem Ergebnis eines Vergleichs eines Differenzwerts der Kriteriumsspitze und eines Differenzwerts der Targetspitze.

## Revendications

1. Appareil de gestion de batterie (100) comprenant :
une unité génératrice de profil (110) configurée pour générer un profil différentiel pour un profil de batterie représentant un rapport correspondant entre la tension et la capacité d'une batterie ; et
un module de contrôle (120) configuré pour déterminer un pic de critère et un pic cible dans le profil différentiel reçu de l'unité génératrice de profil (110) ;
**caractérisé en ce que**
le module de contrôle (120) est configuré en outre pour diagnostiquer un état de la batterie sur la base d'un résultat de la comparaison entre une valeur différentielle du pic de critère et une valeur différentielle du pic cible.

2. Appareil de gestion de batterie (100) selon la revendication 1,
l'unité génératrice de profil (110) étant configurée pour générer au moins un d'un profil de tension différentielle représentant un rapport correspondant entre la capacité et une tension différentielle pour la capacité, et d'un profil de capacité différentielle représentant un rapport correspondant entre la tension et une capacité différentielle pour la tension, en tant que profil différentiel.

3. Appareil de gestion de batterie (100) selon la revendication 2,
le module de contrôle (120) étant configuré pour déterminer d'une part le type de profil différentiel reçu de l'unité génératrice de profil (110), d'autre part le pic de critère et le pic cible dans le profil différentiel reçu conformément à une règle préétablie pour correspondre au type déterminé du profil différentiel.

4. Appareil de gestion de batterie (100) selon la revendication 3,
dans lequel, lorsque le profil de tension différentielle est reçu de l'unité génératrice de profil (110), le module de contrôle (120) est configuré pour classer le profil de tension différentielle en une zone de critère et une zone cible en fonction de la capacité, déterminer un pic présentant la tension différentielle la plus petite dans la zone de critère, en tant que pic de critère, et déterminer un pic présentant la tension différentielle la plus petite dans la zone cible en tant que pic cible.

5. Appareil de gestion de batterie (100) selon la revendication 4,
dans lequel, lorsqu'une valeur de tension différentielle du pic de critère est inférieure à une valeur de tension différentielle du pic cible, le module de contrôle (120) est configuré pour diagnostiquer l'état de la batterie comme étant un état inutilisable, et
dans lequel, lorsque la valeur de tension différentielle du pic de critère est égale ou supérieure à la valeur de tension différentielle du pic cible, le module de contrôle (120) est configuré pour diagnostiquer l'état de la batterie comme étant un état utilisable.

6. Appareil de gestion de batterie (100) selon la revendication 3,
dans lequel lorsque le profil de capacité différentielle est reçu de l'unité génératrice de profil (110), le module de contrôle (120) est configuré pour classer le profil de capacité différentielle en une zone de critère et une zone cible selon la tension, déterminer un pic présentant la capacité différentielle la plus élevée dans la zone de critère en tant que pic de critère, et déterminer un pic présentant la capacité différentielle la plus élevée dans la zone cible en tant que pic cible.

7. Appareil de gestion de batterie (100) selon la revendication 6,
dans lequel lorsqu'une valeur de capacité différentielle du pic de critère est supérieure à une valeur de capacité différentielle du pic cible, le module de contrôle (120) est configuré pour diagnostiquer l'état de la batterie comme étant un état inutilisable, et
dans lequel lorsqu'une valeur de capacité différentielle du pic de critère est inférieure ou égale à la valeur de capacité différentielle du pic cible, le module de contrôle (120) est configuré pour diagnostiquer l'état de la batterie comme étant un état utilisable.

8. Appareil de gestion de batterie (100) selon la revendication 1,
le pic cible étant configuré pour se présenter dans un profil différentiel pour une batterie en haut-nickel contenant une quantité prédéterminée de nickel ou davantage.

9. Appareil de gestion de batterie (100) selon une des revendications 1 à 8, l'état de la batterie comprenant un état utilisable et un état inutilisable (page 9, lignes 1 à 10).

10. Bloc-batterie (10) comprenant l'appareil de gestion de batterie (100) selon une quelconque des revendications 1 à 9.

11. Procédé de gestion de batterie comprenant :
une étape de génération d'un profil différentiel comportant la génération d'un profil différentiel pour un profil de batterie représentant un rapport correspondant entre la tension et la capacité d'une batterie ; et
une étape de détermination d'un pic comportant la détermination d'un pic de critère et d'un pic cible dans le profil différentiel généré au cours de l'étape de génération d'un profil différentiel ;
**caractérisé par**
une étape de diagnostic de l'état d'une batterie comportant le diagnostic d'un état d'une batterie d'après un résultat de la comparaison d'une valeur différentielle du pic de critère avec une valeur différentielle du pic cible.
